(19) Europäisches Patentamt / European Patent Office / Office européen des brevets

(11) **EP 4 403 514 A1**

(12) # EUROPEAN PATENT APPLICATION
published in accordance with Art. 153(4) EPC

(43) Date of publication:
24.07.2024 Bulletin 2024/30

(21) Application number: 22867479.2

(22) Date of filing: 12.09.2022

(51) International Patent Classification (IPC):
**B82B 1/00** (2006.01)

(52) Cooperative Patent Classification (CPC):
**B82B 1/00**

(86) International application number:
**PCT/JP2022/034863**

(87) International publication number:
**WO 2023/038158** (16.03.2023 Gazette 2023/11)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: 13.09.2021 JP 2021148986
17.03.2022 JP 2022043216

(71) Applicant: **Japan Science and Technology Agency**
**Kawaguchi-shi, Saitama 332-0012 (JP)**

(72) Inventors:
• **MAJIMA, Yutaka**
**Tokyo 152-8550 (JP)**
• **YAMAURA, Junichi**
**Tokyo 152-8550 (JP)**
• **KAWACHI, Shiro**
**Tokyo 152-8550 (JP)**
• **HOSONO, Hideo**
**Tokyo 152-8550 (JP)**
• **TOYAMA, Ryo**
**Tokyo 152-8550 (JP)**

(74) Representative: **Murgitroyd & Company**
**165-169 Scotland Street**
**Glasgow G5 8PL (GB)**

(54) **ORDERED ALLOY FERROMAGNETIC NANOWIRE STRUCTURE AND METHOD FOR PRODUCING SAME**

(57)   To provide a suitable method of producing an ordered-alloy ferromagnetic nanowire structure. Disclosed is a method of producing an ordered-alloy ferromagnetic nanowire structure, the method including: forming a nanowire on or above a substrate, the nanowire having a width of 100 nm or less and a length of at least twice the width, and made of an iron group element and a platinum group element; and subjecting the nanowire to heat treatment to obtain an ordered-alloy ferromagnetic nanowire structure in which an ordered-alloy ferromagnetic nanowire made of an ordered alloy of the iron group element and the platinum group element is formed on or above the substrate.

FIG. 1A
FIG. 1B
FIG. 1C
FIG. 1D
FIG. 1E

EP 4 403 514 A1

Processed by Luminess, 75001 PARIS (FR)

**Description**

TECHNICAL FIELD

This disclosure relates to an ordered-alloy ferromagnetic nanowire structure and a method of producing the same.

BACKGROUND

In the field of ferromagnetic materials with strong perpendicular magnetic anisotropy (PMA) and large coercive force (Hc), the technology has been widely studied for application to spintronics devices such as tunnel magneto resistive (TMR) heads used in magnetoresistive random access memory (MRAM) and ultra-high density hard disk drives (HHD), and ferromagnetic single-electron transistors (FM-SET). Among them, ordered alloys of iron group elements and platinum group elements are considered to be one of the most promising next-generation ferromagnetic materials. It is known that alloys of iron group elements and platinum group elements with the A1-disordered phase undergo a phase transition to ordered alloys when subjected to heat treatment under predetermined conditions. For example, when the atomic composition ratio of CoPt is Co:Pt = 1:1, an $L1_0$-ordered CoPt alloy can be obtained. When the atomic composition ratio of CoPt is Co:Pt = 1:3 or 3:1, an $L1_2$-ordered CoPt alloy can be obtained. Although the "L" in $L1_0$ and $L1_2$ is formally written in italics, it is written in normal typeface herein.

The following technologies are known for ordered-alloy ferromagnetic materials. JP 2016-42399 A (PTL 1) describes "[a] magnetic recording medium comprising a substrate made of a non-magnetic material; and a magnetic material layer formed on the substrate, wherein the magnetic material layer includes ordered crystal magnetic nanoparticles having an average particle size of 3 nm to 20 nm formed directly or via a base layer on the substrate, and a protective layer made of an inorganic material for covering a surface of the ordered crystal magnetic nanoparticles to maintain a dispersion state of the ordered crystal magnetic nanoparticles" (see claim 1), and that the ordered crystalline magnetic nanoparticles are $L1_0$-ordered CoPt magnetic nanoparticles (see claim 3).

R. Toyama et al., Formation of $L1_0$-ordered CoPt during interdiffusion of electron-beam-deposited Pt/Co bilayer thin films on Si/SiO$_2$ substrates by rapid thermal annealing, Mater. Res. Express 7 (2020) 066101 (NPL 1) and R. Toyama et al., Ti underlayer effect on the ordering of CoPt in (Cp/Pt)4 multilayer thin films on Si/SiO2 substrates, Jpn. J. Appl. Phys. 59, 075504 (2020) (NPL 2) were authored by the present inventors. NPL 1 describes experiments in which a 3.0 nm thick Ti layer was deposited on SiO$_2$/Si substrates by electron-beam evaporation as an under layer to enhance adhesion, followed by the fabrication of equiatomic bilayer films ($Co_{50}Pt_{50}$) made of a 6.6 nm thick Pt layer and a 4.8 nm thick Co layer, followed by heat treatment by a rapid thermal annealing (RTA) apparatus with temperatures ranging from 200 °C to 900 °C in increments of 100 °C for 30 seconds at a heating rate of 30°C/s under a vacuum. It is shown that at the heat treatment temperature of 800 °C, a graded thin film containing $L1_2$-ordered CoPts, $L1_0$-ordered CoPt, and $L1_2$-ordered CosPt was formed during interdiffusion of Co/Pt bilayer thin films, with an in-plane coercivity of Hc = 2.1 kOe and a saturation magnetization of Ms = 600 emu/cm³.

NPL 2 describes experiments in which a 1.2 nm thick Co layer and a 1.6 nm thick Pt layer were repeatedly stacked four times on SiO$_2$/Si substrates by electron-beam evaporation, followed by the fabrication of equiatomic $(Co/Pt)_4$ eight-layer thin films, followed by heat treatment with a temperature of 900 °C under a vacuum for 1 hour + 30 seconds using an RTA apparatus. It is shown that after the heat treatment, $L1_0$-ordered round CoPt was observed, with an in-plane coercivity of Hc = 2.7 kOe.

Yoshiharu Hotta, et al., "Phase Transformation and Photoemission Electron Microscopy of Fe50Pd50-xNix Processed by Severe Plastic Deformation," SPring-8/SACLA Research Report, January 2021, Vol. 8, No. 3, pp. 493-496 (NPL 3) describes a method in which a mixed powder of $Fe_{50}Pd_{50-x}Ni_x$ (x = 6, 12, 25, 38, 44) is subjected to high-pressure torsion (HPT) processing at a high pressure of 6 GPa, huge strain is introduced for solidification to create a bulk state in a solid solution, and then heat treatment is performed to obtain $L1_0$-ordered alloys.

CITATION LIST

Patent Literature

PTL 1: JP 2016-42399 A

Non-patent Literature

NPL 1: R. Toyama et al., Formation of L10-ordered CoPt during interdiffusion of electron-beam-deposited Pt/Co bilayer thin films on Si/SiO2 substrates by rapid thermal annealing, Mater. Res. Express 7 (2020) 066101

NPL 2: R. Toyama et al., Ti underlayer effect on the ordering of CoPt in (Cp/Pt)4 multilayer thin films on Si/SiO2 substrates, Jpn. J. Appl. Phys. 59, 075504 (2020)

NPL 3: Yoshiharu Hotta, et al., "Phase Transformation and Photoemission Electron Microscopy of Fe50Pd50-xNix Processed by Severe Plastic Deformation," SPring-8/SACLA Research Report, January 2021, Vol. 8, No. 3, pp. 493-496

SUMMARY

(Technical Problem)

The efficient production of ordered alloys at the nanoscale would be very advantageous from the viewpoint of application to various spintronics devices. In particular, if wire-type ordered alloys can be formed during the semiconductor process, useful applications such as facilitating miniaturization of MTR devices are possible. However, in PTL 1, $L1_0$-ordered CoPt magnetic nanoparticles were fabricated, in NPLs 1 and 2, CoPt thin films containing $L1_0$ phase were fabricated, and in NPL 3, materials of FePdNi $L1_0$-ordered alloys in bulk form were fabricated, and hence none of them fabricate ordered-alloy nanowires. Until now, no suitable method has been found to efficiently fabricate ordered-alloy ferromagnetic nanowires with nanometer-order widths as narrow as 100 nm or less.

It would thus be helpful to provide an ordered-alloy ferromagnetic nanowire structure and a suitable method of producing the same.

(Solution to Problem)

In order to solve the above issues, the present inventors conducted a diligent study and made the following findings. By combining the deposition of an iron group element and a platinum group element with the lift-off process, a nanowire made of the iron group element and the platinum group element can be produced. The present inventors found that if the width of the nanowire is limited below a predetermined upper limit and the nanowire is subjected to heat treatment under predetermined conditions, the iron group element and the platinum group element in the nanowire become an ordered alloy, and an ordered-alloy ferromagnetic nanowire can be obtained.

In addition, if the width of the nanowire is set to a predetermined lower limit or higher and the ratio of thickness to width (hereinafter referred to as "aspect ratio") in a cross-section perpendicular to a direction in which the nanowire extends is set to a predetermined value or higher, and if the nanowire is subjected to heat treatment under predetermined conditions, the iron group element and the platinum group element become an ordered alloy without interruption in the nanowire, and an ordered-alloy ferromagnetic nanowire with a sufficient length can be obtained. As used herein, "nanowire" means a nanowire that is made of an iron group element and a platinum group element before undergoing heat treatment, and "ordered-alloy ferromagnetic nanowire" means a ferromagnetic nanowire that is formed by the nanowire undergoing heat treatment and made of an ordered alloy of the iron group element and the platinum group element.

Based on these discoveries, we provide:

[1] A method of producing an ordered-alloy ferromagnetic nanowire structure, the method comprising:

forming a nanowire on or above a substrate, the nanowire having a width of 100 nm or less and a length of at least twice the width, and made of an iron group element and a platinum group element; and
subjecting the nanowire to heat treatment to obtain an ordered-alloy ferromagnetic nanowire structure in which an ordered-alloy ferromagnetic nanowire made of an ordered alloy of the iron group element and the platinum group element is formed on or above the substrate.

[2] The method of producing an ordered-alloy ferromagnetic nanowire structure according to [1], wherein a ratio of thickness to width is 0.7 or more and 3.0 or less in a cross-section perpendicular to a direction in which the nanowire extends.
[3] The method of producing an ordered-alloy ferromagnetic nanowire structure according to [1] or [2], wherein the length of the nanowire is 800 nm or more.
[4] The method of producing an ordered-alloy ferromagnetic nanowire structure according to any one of [1] to [3], wherein the nanowire is formed on the substrate.
[5] The method of producing an ordered-alloy ferromagnetic nanowire structure according to any one of [1] to [4], wherein the substrate is a magnesium oxide substrate, an alumina substrate, a strontium titanate substrate, or a silicon substrate with a silicon oxide film formed on a surface thereof.
[6] The method of producing an ordered-alloy ferromagnetic nanowire structure according to any one of [1] to [5], wherein the nanowire is fabricated by alternately depositing the iron group element and the platinum group element by electron-beam evaporation such that the nanowire is formed from an alternate layered structure of a first layer and a second layer, the first layer made of the iron group element and the second layer made of the platinum group element.
[7] The method of producing an ordered-alloy ferromagnetic nanowire structure according to [6], wherein the first layer has a thickness of 2.0 nm or more and 15 nm or less, the second layer has a thickness of 3.0 nm or more and 15 nm or less, and a total number of layers of the first layer and the second layer is 2 or more and 24 or less.
[8] The method of producing an ordered-alloy ferromagnetic nanowire structure according to any one of [1] to [5], wherein the nanowire is fabricated by depositing the iron group element and the platinum group element simultaneously by electron-beam evaporation or sputtering such that the nanowire is formed from a composite of the iron group element and the platinum group element.

[9] The method of producing an ordered-alloy ferromagnetic nanowire structure according to any one of [1] to [8], wherein the heat treatment is performed in an atmosphere containing hydrogen and inert gas.

[10] The method of producing an ordered-alloy ferromagnetic nanowire structure according to any one of [1] to [9], wherein the heat treatment is performed at a heat treatment temperature of 500 °C or higher and 900 °C or lower for a heat treatment time of 30 minutes or more and 360 minutes or less.

[11] The method of producing an ordered-alloy ferromagnetic nanowire structure according to any one of [1] to [10], wherein the nanowire has an atomic composition ratio of the iron group element to the platinum group element of 1:1 such that the ordered-alloy ferromagnetic nanowire made of an $L1_0$-ordered alloy is obtained.

[12] The method of producing an ordered-alloy ferromagnetic nanowire structure according to any one of [1] to [10], wherein the nanowire has an atomic composition ratio of the iron group element to the platinum group element of 1:3 or 3:1 such that the ordered-alloy ferromagnetic nanowire made of an $L1_2$-ordered alloy is obtained.

[13] The method of producing an ordered-alloy ferromagnetic nanowire structure according to any one of [1] to [12], wherein the iron group element is Co, Fe, or Ni and the platinum group element is Pt or Pd.

[14] An ordered-alloy ferromagnetic nanowire structure comprising:

a substrate; and
an ordered-alloy ferromagnetic nanowire formed on or above the substrate, having a width of 100 nm or less and a length of at least twice the width, and made of an ordered alloy of an iron group element and a platinum group element.

[15] The ordered-alloy ferromagnetic nanowire structure according to [14], wherein the ordered-alloy ferromagnetic nanowire has a length of 800 nm or more.

[16] The ordered-alloy ferromagnetic nanowire structure according to [14] or [15], wherein the ordered-alloy ferromagnetic nanowire is formed on the substrate.

[17] The ordered-alloy ferromagnetic nanowire structure according to any one of [14] to [16], wherein the substrate is a magnesium oxide substrate, an alumina substrate, a strontium titanate substrate, or a silicon substrate with a silicon oxide film formed on a surface thereof.

[18] The ordered-alloy ferromagnetic nanowire structure according to any one of [14] to [17], wherein the ordered-alloy ferromagnetic nanowire is an $L1_0$-ordered alloy.

[19] The ordered-alloy ferromagnetic nanowire structure according to any one of [14] to [17], wherein the ordered-alloy ferromagnetic nanowire is an $L1_2$-ordered alloy.

[20] The ordered-alloy ferromagnetic nanowire structure according to any one of [14] to [19], wherein a contact width of the ordered-alloy ferromagnetic nanowire with the substrate is smaller than a maximum width of the ordered-alloy ferromagnetic nanowire in a cross-section perpendicular to a direction in which the ordered-alloy ferromagnetic nanowire extends.

[21] The ordered-alloy ferromagnetic nanowire structure according to any one of [14] to [20], wherein the ordered-alloy ferromagnetic nanowire contains a plurality of grains connected together, each of the plurality of grains made of a single crystal including twinned crystals.

[22] The ordered-alloy ferromagnetic nanowire structure according to any one of [14] to [21], wherein the iron group element is Co, Fe, or Ni and the platinum group element is Pt or Pd.

(Advantageous Effect)

According to the production method disclosed herein, an ordered-alloy ferromagnetic nanowire structure can be suitably produced.

BRIEF DESCRIPTION OF THE DRAWINGS

In the accompanying drawings:

FIGS. 1A to 1E are diagrams illustrating a method of producing an ordered CoPt ferromagnetic nanowire structure 100 according to an embodiment of the present disclosure;
FIGS. 2A to 2C are diagrams illustrating cross-sectional shapes of CoPt nanowires 16 perpendicular to the direction in which the CoPt nanowires 16 extend in Experimental Examples 1-3;
FIG. 3 illustrates SEM images of the top surfaces of the samples (upper side) and GI-XRD patterns (lower side) obtained in Experimental Example 1 for instances where the heat treatment temperature was 650 °C and the heat treatment time was 120 mins, 180 mins, 300 mins, and 360 mins;
FIG. 4A illustrates VSM measurement results (left side) and an SEM image of the top surface of the sample (right side) obtained in Experimental Example 1 for the instance where the heat treatment temperature was 650 °C and the heat treatment time was 180 mins;
FIG. 4B illustrates VSM measurement results (left side) and an SEM image of the top surface of the sample (right side) obtained in Experimental Example 1 for the instance where the heat treatment temperature was 650 °C and the heat treatment time was 300 mins;

FIG. 5 illustrates SEM images of the top surfaces of the samples (upper side) and GI-XRD patterns (lower side) obtained in Experimental Example 2 for instances where the heat treatment temperature was 650 °C and the heat treatment time was 30 mins, 60 mins, and 90 mins;

FIG. 6 illustrates SEM images of the top surfaces of the samples obtained in Experimental Example 3 for instances where the heat treatment temperature was 650 °C and the heat treatment time was 30 mins, 60 mins, and 90 mins;

FIG. 7 illustrates an SEM image of the top surface of the sample (left side) and a GI-XRD pattern (right side) obtained in Experimental Example 3 for the instance where the heat treatment temperature was 650 °C and the heat treatment time was 90 mins;

FIG. 8 illustrates VSM measurement results (left side) and an SEM image of the top surface of the sample (right side) obtained in Experimental Example 3 for the instance where the heat treatment temperature was 650 °C and the heat treatment time was 90 mins;

FIG. 9 illustrates a cross-sectional TEM image perpendicular to the direction in which an ordered CoPt ferromagnetic nanowire extends (left side) and an SEM image of the top surface of the sample (right side) obtained in Experimental Example 3 for the instance where the heat treatment temperature was 650 °C and the heat treatment time was 90 mins;

FIG. 10 illustrates a cross-sectional TEM image perpendicular to the width direction along the direction in which an ordered CoPt ferromagnetic nanowire extends (left side) and an SEM image of the top surface of the sample (right side) obtained in Experimental Example 3 for the instance where the heat treatment temperature was 650 °C and the heat treatment time was 90 mins;

FIG. 11A illustrates a cross-sectional STEM image perpendicular to the direction in which an ordered CoPt ferromagnetic nanowire extends obtained in Experimental Example 3 for the instance where the heat treatment temperature was 650 °C and the heat treatment time was 90 mins;

FIG. 11B illustrates an enlarged STEM image of the upper part of the ordered CoPt ferromagnetic nanowire shown in FIG. 11A;

FIG. 11C illustrates an enlarged STEM image of the lower part of the ordered CoPt ferromagnetic nanowire shown in FIG. 11A; and

FIG. 11D illustrates a STEM image of a magnified view of the side of the ordered CoPt ferromagnetic nanowire obtained in the Experimental Example 3 for the instance where the heat treatment temperature was 650°C and the heat treatment time was 90 mins.

## DETAILED DESCRIPTION

(Method of Producing Ordered-alloy Ferromagnetic Nanowire Structure)

A method of producing an ordered-alloy ferromagnetic nanowire structure according to the present disclosure comprises: forming a nanowire on or above a substrate, the nanowire having a width of 100 nm or less and a length of at least twice the width, and made of an iron group element and a platinum group element; and subjecting the nanowire to heat treatment to obtain an ordered-alloy ferromagnetic nanowire structure in which an ordered-alloy ferromagnetic nanowire made of an ordered alloy of the iron group element and the platinum group element is formed on or above the substrate.

From the viewpoint of chemical stability and defect-resistant structure, it is possible to use any of Co, Fe, and Ni as the iron group element, and any of platinum (Pt), palladium (Pd), ruthenium (Ru), rhodium (Rh), osmium (Os), and iridium (Ir) as the platinum group element. As the platinum group element, any of Pt and Pd, which have low melting points, can be suitably used. In the present disclosure, the combination of the iron group element and the platinum group element can be any combination selected from the above elements. The following is a typical example of an embodiment in which Co is used as the iron group element and Pt as the platinum group element to produce an ordered CoPt ferromagnetic nanowire structure. However, the present disclosure is not limited to this embodiment. The following description applies to any combination of iron group elements and platinum group elements.

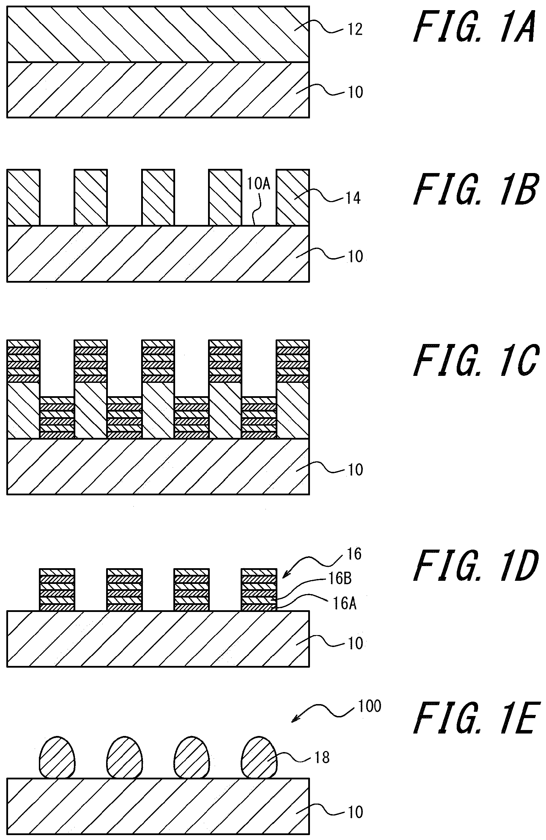

Referring to FIGS. 1A to 1E, a method of producing an ordered CoPt ferromagnetic nanowire structure 100 according to an embodiment of the present disclosure comprises:

(I) forming CoPt nanowires 16 on or above a substrate 10 by the following steps (I-1) to (I-4):

(I-1) forming an electron beam resist film 12 on or above the substrate 10 (FIG. 1A);
(I-2) irradiating the electron beam resist film 12 with an electron beam and subsequently developing it to form a mask pattern 14 with the substrate 10 exposed in the shape of nanowires (FIG. 1B);
(I-3) depositing Co and Pt on exposed portions 10A of the substrate 10 and on the mask pattern 14 (FIG. 1C); and
(I-4) removing the mask pattern 14 (FIG. 1D); and

(II) subjecting the CoPt nanowires 16 to heat treatment to cause ordering of CoPt so as to obtain ordered CoPt ferromagnetic nanowires 18 (FIG. 1E).

[Step (I): Fabrication of CoPt Nanowires 16]

The step (I) of forming CoPt nanowires 16 on or above the substrate 10 will be described in detail below.

[Step (I-1)]

Referring to FIG. 1A, in the step (I-1), an electron beam resist film 12 is formed on or above the substrate 10. The electron beam resist film 12 can be formed by applying a photoresist composition for electron beam exposure onto the substrate 10 and allowing it to dry. The application method is not particularly limited, yet spin-coating can be suitably used. The thickness of the electron beam resist film 12 may be set appropriately to be thicker than the thickness of CoPt nanowires 16 to be formed.

The substrate 10 is not limited as long as it is rigid enough to support the CoPt nanowires 16 and has an insulating surface. However, the substrate 10 is preferably a magnesium oxide (MgO) substrate, an alumina ($Al_2O_3$) substrate, a strontium titanate (SrTiOs) substrate (STO substrate), or a silicon substrate with a silicon oxide film formed on a surface thereof (referred to herein as "$SiO_2$/Si substrate"). Since these substrates are suitable as substrates for various spintronics devices, the formation of ordered CoPt ferromagnetic nanowires on or above these substrates is expected to be applicable to various spintronics devices. In particular, the substrate 10 is preferably a $SiO_2$/Si substrate. This setup makes it possible to fabricate elements of various spintronics devices on or above the same substrate as ICs and ULSIs that integrate circuits using Si semiconductors. The shape and dimensions of the substrate 10 are not particularly limited, yet in a case where a substrate with a rectangular main surface is used as the substrate 10, the dimensions can be, for example, 4 mm to 300 mm in length × 4 mm to 300 mm in width × 0.3 mm to 1.2 mm in thickness.

[Step (I-2)]

Referring now to FIG. 1B, in the step (I-2), the electron beam resist film 12 is irradiated with an electron beam and then developed to form the mask pattern 14 with the substrate 10 exposed in the shape of nanowires. In other words, the mask pattern 14 is fabricated by exposing the electron beam resist film 12 by electron beam lithography and developing it. The shape of the mask pattern 14 may be set appropriately according to the width and length of the CoPt nanowires 16 to be formed. In the mask pattern 14, the substrate 10 is exposed at those portions where the electron beam resist film 12 has been removed, thereby forming exposed portions 10A.

[Step (I-3)]

Referring now to FIG. 1C, in the step (I-3), Co and Pt are deposited on the exposed portions 10A of the substrate 10 and on the mask pattern 14 to form CoPt deposition layers. The deposition method can be, for example, electron-beam evaporation or sputtering.

[Step (I-4)]

Referring now to FIG. 1D, in the step (I-4), the mask pattern 14 is removed. In other words, through a lift-off process to peel off the mask pattern 14 and remove the CoPt deposition layers formed thereon, the CoPt deposition layers formed on the exposed portions 10A of the substrate 10 are left, and CoPt nanowires 16 can be formed on or above the substrate 10.

[Structure of CoPt Nanowires 16]

By combining the above steps (I-1) through (I-4), i.e., electron beam lithography and deposition of Co and Pt by electron-beam evaporation, CoPt nanowires 16 can be fabricated on or above the substrate 10. As can be seen from FIG. 1D, the cross-sectional shape perpendicular to the direction in which the CoPt nanowires 16 extend is rectangular. In this embodiment illustrated in FIGS. 1A to 1D, the mask pattern was formed by electron beam lithography, yet the present disclosure is not so limited. The mask pattern can be formed by any method capable of forming a nanometer-scale fine mask pattern, including UV lithography, nanoimprinting, and ArF immersion lithography.

In the present disclosure, it is important that the width of the CoPt nanowires 16 be 100 nm or less. If the width exceeds 100 nm, it is difficult to cause ordering of CoPt while maintaining the shape of nanowires. Therefore, the width of the CoPt nanowires 16 is 100 nm or less, and preferably 50 nm or less. With this setup, by subjecting the CoPt nanowires 16 to heat treatment under optimized conditions, the CoPt nanowires 16 can be ordered, making is possible to obtain ordered CoPt ferromagnetic nanowires 18. From the viewpoint of making the CoPt nanowires 16 less likely to break, or less prone to interruption, the width of the CoPt nanowires 16 is 10 nm or more, and preferably 20 nm or more. This is necessary to obtain ordered CoPt ferromagnetic nanowires 18 with sufficient length.

The aspect ratio in the cross-section perpendicular to the direction in which the CoPt nanowires 16 extend is preferably 0.7 or more, and more preferably 1.5 or more. The aspect ratio is preferably 3.0 or less, more preferably 2.8 or less, and even more preferably 2.5 or less. With the width of the CoPt nanowires 16 set to 10 nm or more and the aspect ratio to 0.7 or more, preferably 1.5 or more, by subjecting the CoPt nanowires 16 to heat treatment under optimized conditions, the CoPt nanowires 16 can be ordered without interruption, making it possible to obtain ordered CoPt ferromagnetic nanowires 18 with sufficient length. In other words, setting of the aspect ratio is also necessary to obtain ordered CoPt ferromagnetic nanowires 18 with sufficient length. On the other hand, if the aspect ratio exceeds 3.0, it becomes difficult to form the CoPt nanowires 16 by the lift-off process. From this perspective, the aspect ratio is preferably 3.0 or less, more preferably 2.8 or less, and even more preferably 2.5 or less.

The length of the CoPt nanowires 16 is not limited as long as it is at least twice the width. In other words, in the present disclosure, a structure with a length that is at least twice the width is referred to as a "nanowire". However, from the viewpoint of obtaining ordered CoPt ferromagnetic nanowires 18 with sufficient length, the length of the CoPt nanowires 16 is preferably 800 nm or more, more preferably 1 μm or more, and even more preferably 10 μm or more. On the other hand, due to process constraints, the length of the CoPt nanowires 16 is preferably 10 mm or less.

In one embodiment, the atomic composition ratio of the CoPt nanowires 16 can be Co:Pt = 1:1. In this case, the CoPt nanowires 16 can be subjected to heat treatment under predetermined conditions to obtain ordered CoPt ferromagnetic nanowires 18, which are $L1_0$-ordered CoPt.

In another embodiment, the atomic composition ratio of the CoPt nanowires 16 can be Co:Pt = 1:3 or 3:1. In this case, the CoPt nanowires 16 can be subjected to heat treatment under predetermined conditions to obtain ordered CoPt ferromagnetic nanowires 18, which are $L1_2$-ordered CoPt.

In one embodiment, as can be seen from FIGS. 1C and 1D, in the step (I-3), by depositing Co and Pt alternately by electron-beam evaporation, it is possible to obtain CoPt nanowires 16 formed from an alternate layered structure of Co layers 16A as first layers and Pt layers 16B as second layers. In this case, the layer to be deposited first may be a Co layer or a Pt layer. The thickness of each Co layer, the thickness of each Pt layer, and the total number of layers of Co and Pt layers may be determined as appropriate to achieve the desired atomic composition ratio.

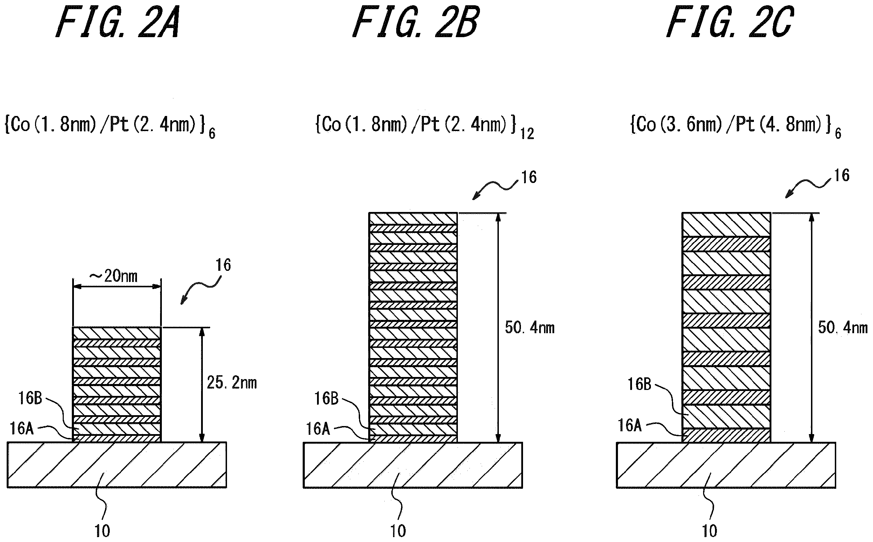

However, as can be seen from FIG. 2C, for example, it is preferable that the thickness of each Co layer be 2.0 nm or more and 15 nm or less, the thickness of each Pt layer be 3.0 nm or more and 15 nm or less, and the total number of layers of Co and Pt layers be 2 or more and 24 or less. In this case, the CoPt nanowires 16 are ordered without interruption, and the degree of freedom of heat treatment conditions to obtain ordered CoPt ferromagnetic nanowires 18 with sufficient length was found to be very large.

In another embodiment, in the step (I-3), by depositing Co and Pt simultaneously by electron-beam evaporation or sputtering, CoPt nanowires formed from a CoPt composite can be obtained. The Co and Pt feed ratios may be determined as appropriate to achieve the desired atomic composition ratio.

In this embodiment, there should be no adhesive layer such as a Ti layer between the substrate 10 and the CoPt nanowires 16. In other words, the CoPt nanowires 16 are preferably formed on (i.e., in contact with) the substrate 10. This setup will promote the ordering of CoPt, since Ti does not interfere with such ordering due to its migration.

[Step (II): Heat Treatment]

Referring now to FIGS. 1D and 1E, in the step (II), the CoPt nanowires 16 are subjected to heat treatment for ordering of CoPt to obtain ordered CoPt ferromagnetic nanowires 18. In this way, an ordered CoPt ferromagnetic nanowire structure 100 with the ordered CoPt ferromagnetic nanowires 18 formed on or above the substrate 10 is fabricated.

The heat treatment is performed preferably in an atmosphere containing hydrogen and inert gas, and more preferably in an atmosphere containing hydrogen with the balance being inert gas and gases of inevitable impurities that may optionally be contained. Performing the heat treatment in a hydrogencontaining atmosphere can promote the ordering of CoPt. The hydrogen content is preferably 1 vol% to 5 vol%, and the inert gas in the balance can be one or more selected from the group consisting of, for example, argon (Ar), helium (He), and neon (Ne).

In the step (II), the heat treatment temperature is preferably 500 °C or higher and 900 °C or lower, and the heat treatment time is preferably 30 mins or more and 360 mins or less. As used herein, "heat treatment temperature" means the ambient temperature during heat treatment. In addition, "heat treatment time" means the holding time at the heat treatment temperature. If the heat treatment temperature is lower than 500 °C, Co and Pt do not interdiffuse, and ordering does not occur. If the heat treatment temperature exceeds 900 °C, the ordered CoPt becomes disordered again due to thermal disturbance. If the heat treatment time is less than 30 mins, neither interdiffusion nor surface diffusion necessary for ordering take place sufficiently. If the heat treatment time exceeds 360 mins, the ordered CoPt becomes disordered again due to thermal disturbance.

These heat treatment temperatures and heat treatment times are in the range necessary for the ordering of CoPt. In order to obtain ordered CoPt ferromagnetic nanowires 18 with sufficient length in which the CoPt nanowires 16 are ordered without interruption, it is preferable to select an optimized range from among the aforementioned ranges as appropriate depending on the structure of the CoPt nanowires 16 (such as the width, the aspect ratio, the atomic composition ratio, the thickness of each Co layer, the thickness of each Pt layer, and the total number of layers of Co and Pt layers).

The means of heat treatment is not limited, and general heat treatment furnaces may be used, or Rapid Thermal Anneal (RTA) equipment may be used.

(Ordered-alloy Ferromagnetic Nanowire Structure)

The ordered-alloy ferromagnetic nanowire structure according to the present disclosure comprises: a substrate; and an ordered-alloy ferromagnetic nanowire formed on or above the substrate, the ordered-alloy ferromagnetic nanowire having a width of 100 nm or less and a length of at least twice the width, and made of an ordered alloy of an iron group element and a platinum group element.

From the viewpoint of chemical stability and defect-resistant structure, it is possible to use any of Co, Fe, and Ni as the iron group element, and any of platinum (Pt), palladium (Pd), ruthenium (Ru), rhodium (Rh), osmium (Os), and iridium (Ir) as the platinum group element. As the platinum group element, any of Pt and Pd, which have low melting points, can be suitably used. In the present disclosure, the combination of the iron group element and the platinum group element can be any combination selected from the above elements. The following is a typical example of an embodiment of an ordered CoPt ferromagnetic nanowire structure in which Co is used as the iron group element and Pt as the platinum group element. However, the present disclosure is not limited to this embodiment. The following description applies to any combination of iron group elements and platinum group elements.

Referring to FIG. 1E, an ordered CoPt ferromagnetic nanowire structure 100 according to an embodiment of the present disclosure is suitably produced by the method according to the above-described embodiment, comprising: the substrate 10; and the ordered CoPt ferromagnetic nanowires 18 formed on or above the substrate 10, having a width of 100 nm or less and a length of at least twice the width.

[Substrate]

The description of the substrate 10 is covered in the previous section.

[Ordered CoPt ferromagnetic nanowires]

The ordered CoPt ferromagnetic nanowires 18 are either $L1_0$ ordered CoPt or $L1_2$ ordered CoPt, depending on the atomic composition ratio of the CoPt nanowires 16 before the heat treatment. As used herein, "$L1_0$-ordered CoPt" means that superlattice reflections due to $L1_0$-ordered CoPt 001,110 are observed in the GI-XRD pattern obtained by the GI-XRD measurement as described in the EXAMPLES section below. Similarly, as used herein, "$L1_2$-ordered CoPt" means that in the case of $L1_2$-ordered CosPt, due to the Co-rich, cubic ordered structure with small atomic radius, superlattice reflections due to $L1_2$-ordered CosPt 001,110 are observed on the higher angle side compared to the peaks of $L1_0$-or-

dered CoPt 001,110 in the GI-XRD pattern obtained by the GI-XRD measurement as described in the EXAMPLES section below. In addition, as used herein, "$L1_2$-ordered CoPt" means that in the case of $L1_2$-ordered CoPts, due to the Pt-rich, cubic ordered structure with large atomic radius, superlattice reflections due to $L1_2$-ordered CoPts 100,110 are observed on the lower angle side compared to the peaks of $L1_0$-ordered CoPt 001,110 in the GI-XRD pattern obtained by GI-XRD measurement as described in the EXAMPLES section below.

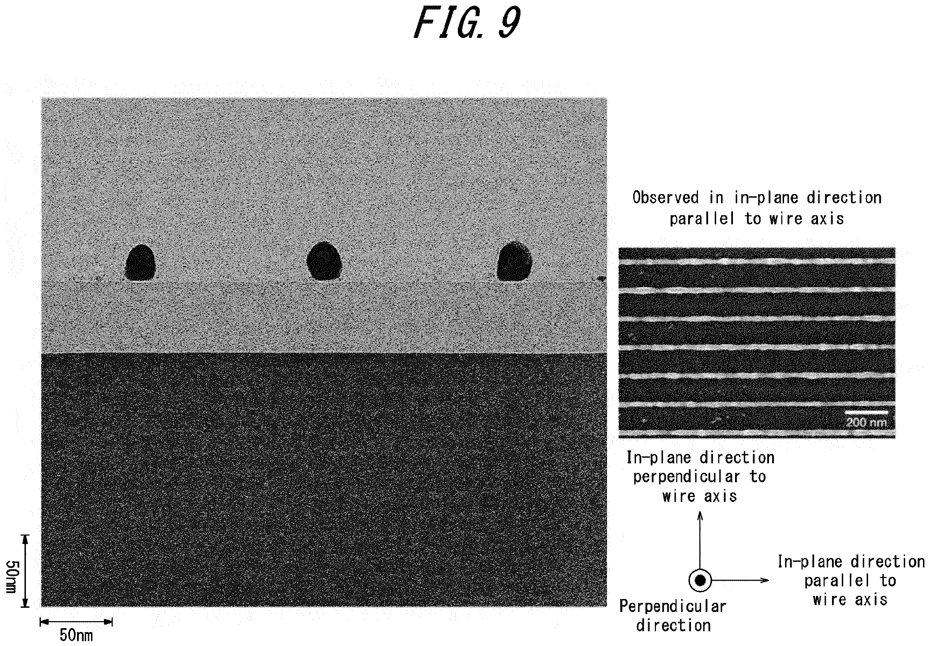

As illustrated in FIG. 9, the cross-sectional shape perpendicular to the direction in which the ordered CoPt ferromagnetic nanowires 18 extend is generally rounded except for the portions of contact with the substrate 10. That is, the cross-sectional shape is such that the contact width of each ordered CoPt ferromagnetic nanowire 18 with the substrate 10 is smaller than the maximum width of the ordered CoPt ferromagnetic nanowire 18. In other words, in the cross-section perpendicular to the direction in which the ordered CoPt ferromagnetic nanowires 18 extend, the width of each ordered CoPt ferromagnetic nanowire 18 takes a maximum value near the center of the height direction and decreases gradually away in the height direction from the height position that takes this maximum value. The reason for this shape is that the CoPt nanowires 16, each of which has a rectangular cross-sectional shape perpendicular to the direction of extension, are subjected to extremely high stress (pressure) during the heat treatment. That is, letting $\Delta P$ be the pressure difference applied in the CoPt nanowires 16, $\gamma$ be the surface tension, and r be the curvature radius, the following equation holds:

$$\Delta P = 2\gamma/r.$$

The surface tension of the iron group element and the platinum group element is about 2000 mN/m, and the pressure difference $\Delta P$ at which $L1_0$ ordering occurs is about 100 MPa. In this situation of large pressure difference, Co and Pt are $L1_0$-ordered as they undergo interdiffusion and even surface diffusion under surface tension. During ordering, the cross-sectional shape is deformed and slightly collapsed so that the CoPt nanowires 16 are blunted in the direction of increasing curvature radius to reduce surface energy. Accordingly, $L1_0$ ordering occurs if the curvature radius r is within 50 nm. This is consistent with the present finding that the width of nanowires is 100 nm or less. Such a geometry has the advantage that magnetization can be formed in all directions because the c-axis of the crystal tends to orient radially in the cross-section perpendicular to the direction in which the ordered CoPt ferromagnetic nanowires 18 extend.

The width of the ordered CoPt ferromagnetic nanowires 18 is 100 nm or less, preferably 10 nm or more, more preferably 20 nm or more, and preferably 50 nm or less. As used herein, the "width of the ordered CoPt ferromagnetic nanowires 18" means the maximum width in a cross-section perpendicular to the direction in which the ordered CoPt ferromagnetic nanowires 18 extend.

The thickness of the ordered CoPt ferromagnetic nanowires 18 depends on the aspect ratio of the CoPt nanowires 16 before the heat treatment. In this embodiment, however, the thickness is 10 nm or more and 100 nm or less. It is preferably 20 nm or more. It is preferably 50 nm or less.

The length of the ordered CoPt ferromagnetic nanowires 18 is not limited as long as it is at least twice the width. However, in order for the ordered CoPt ferromagnetic nanowires 18 to have a sufficient length, the length of the ordered CoPt ferromagnetic nanowires 18 is preferably 800 nm or more, more preferably 1 $\mu$m or more, and even more preferably 10 $\mu$m or more. On the other hand, due to process constraints, the length of the ordered CoPt ferromagnetic nanowires 18 is preferably 10 mm or less.

In this embodiment, there should be no adhesive layer such as a Ti layer between the substrate 10 and the ordered CoPt ferromagnetic nanowires 18. In other words, the ordered CoPt ferromagnetic nanowires 18 are preferably located on (i.e., in contact with) the substrate 10.

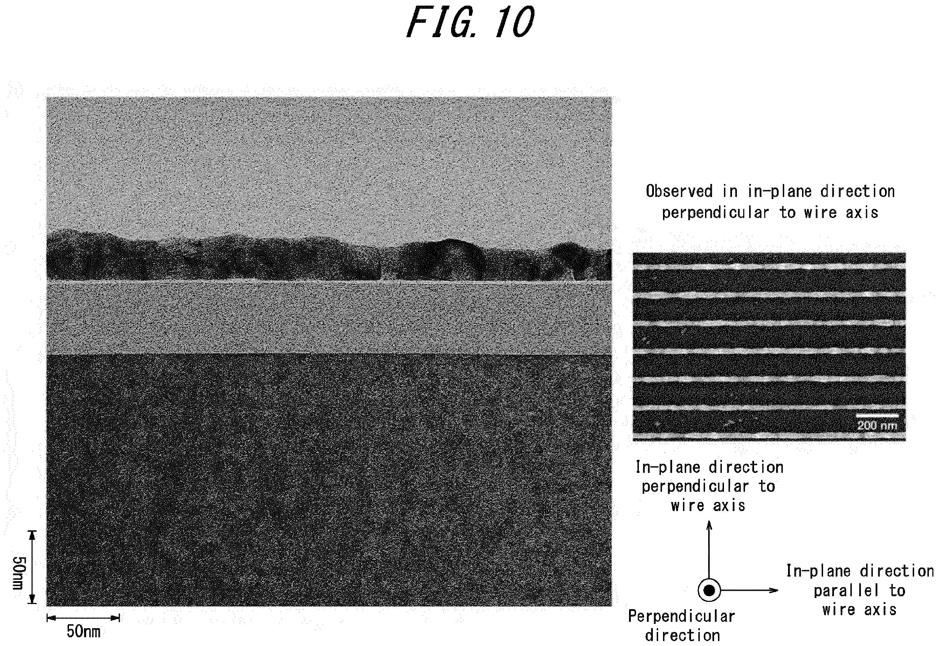

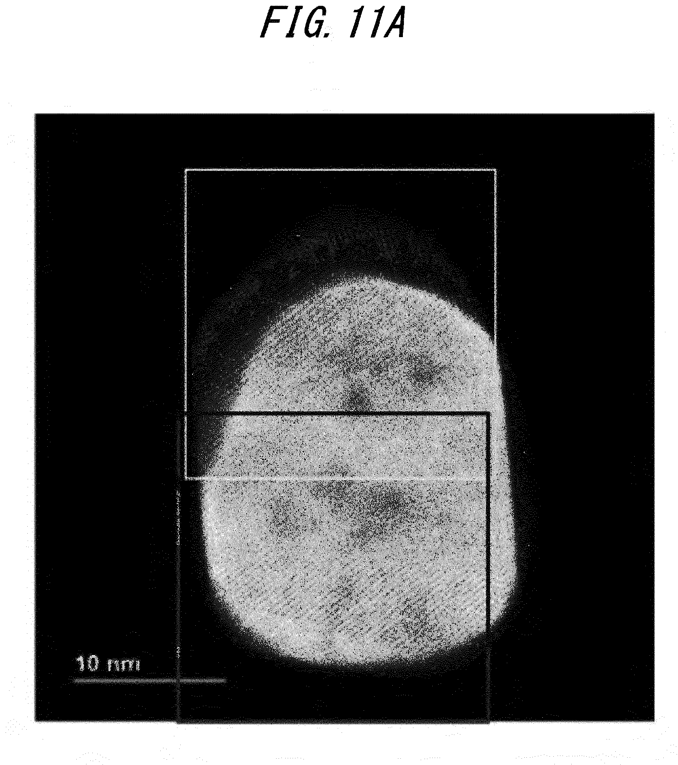

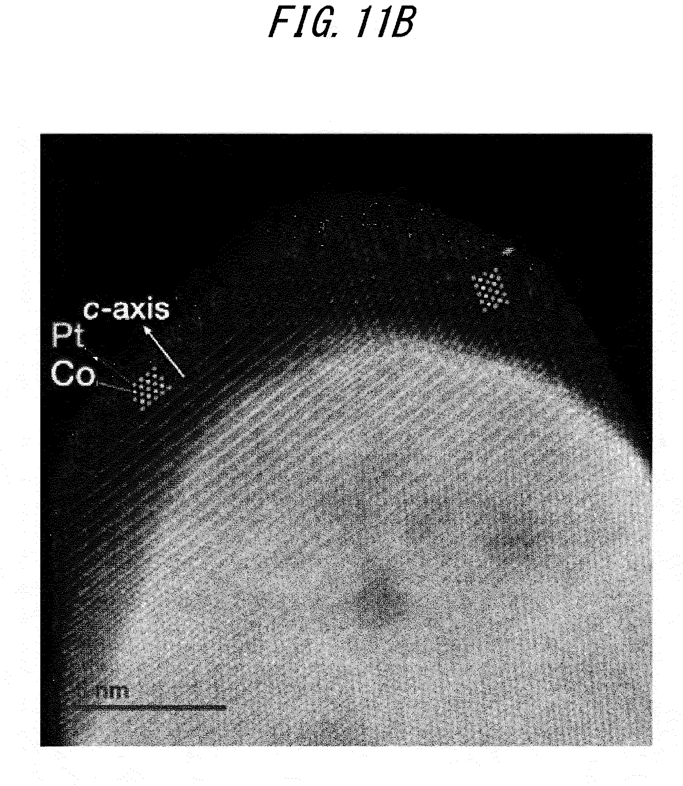

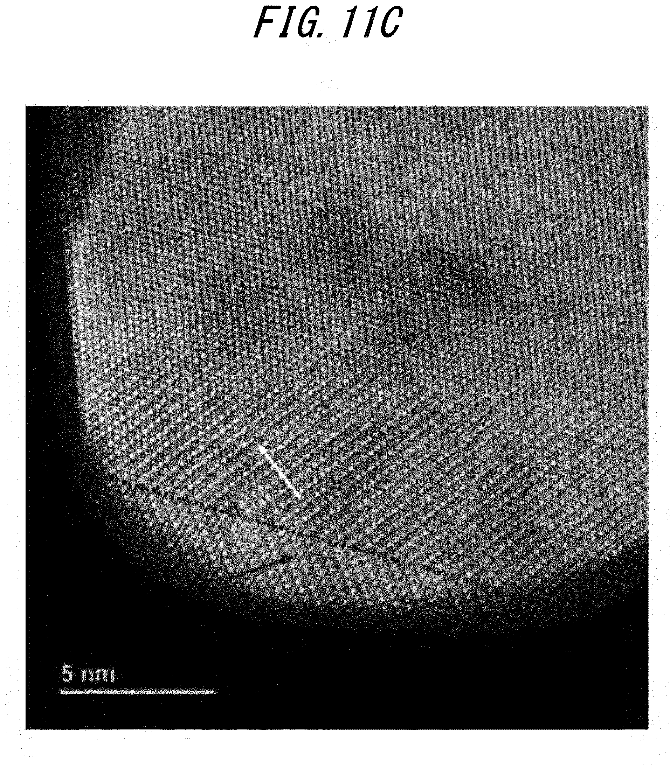

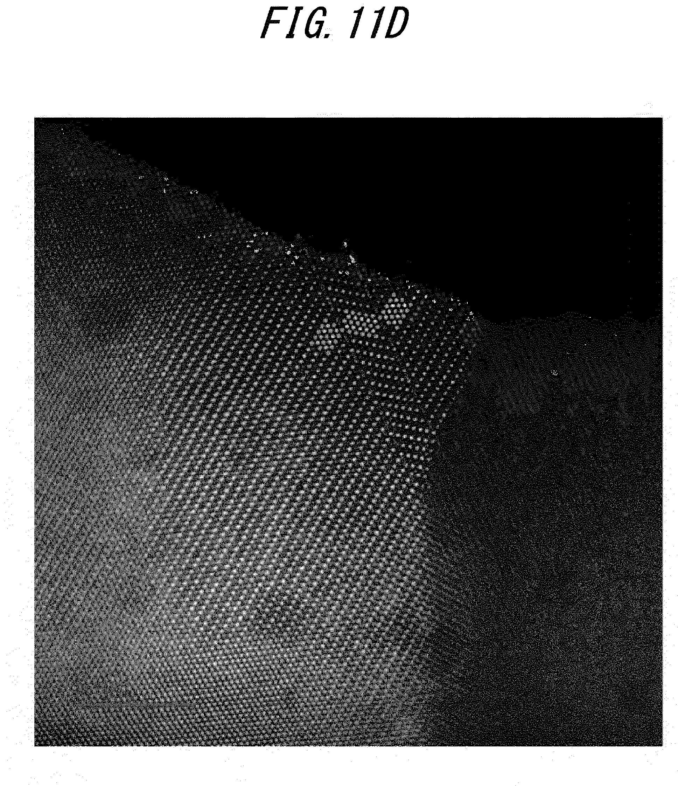

In this embodiment, the ordered CoPt ferromagnetic nanowires 18 are preferably $L1_0$-ordered or $L1_2$-ordered in their entirety. In this embodiment, the ordered CoPt ferromagnetic nanowires 18 each contain a plurality of grains connected together, as will be explained in detail in the EXAMPLES section with reference to FIG. 10. As will be explained in detail with reference to FIGS. 11A, 11B, 11C, and 11D in the EXAMPLES section, in this embodiment, each of the plurality of grains of the ordered CoPt ferromagnetic nanowires 18 is made of a single crystal including twinned crystals. The c-axis is randomized for each grain. Since each grain is made of a single crystal, high coercive force can be achieved. Moreover, in this embodiment, since the ordered CoPt ferromagnetic nanowires 18 each contain a plurality of grains connected together, each of which is made of a single crystal including twinned crystals, even if a thin insulator film is formed on each ordered CoPt ferromagnetic nanowire 18 and then planarized to expose the nanowire surface by polishing with CMP or the like, the effect that a single-crystal ordered ferromagnetic material can be used is obtained.

EXAMPLES

[Experimental Example 1]

<Sample Preparation>

A Si (100) substrate (6 mm long x 4 mm wide x 525 $\mu$m thick) with a surface layer of approximately 50 nm made of SiO$_2$ (hereinafter referred to as "SiO$_2$/Si substrate") was prepared. An electron beam resist (ZEP-520A available from ZEON Corporation) was applied to the SiO$_2$/Si substrate by spin coating to form an electron beam resist film. The electron beam resist film was then irradiated with electron beam using an electron beam writer (ELS-7500EX available from Elionix Inc.) and subsequently developed to form a mask pattern with the SiO$_2$/Si substrate exposed in the shape of nanowires. Then, Co and Pt were alternately deposited on the exposed portions of the SiO$_2$/Si substrate and on the mask pattern by electron-beam evaporation. Then, CoPt nanowires were formed on the SiO$_2$/Si substrate through a lift-off process to peel off the mask pattern.

The cross-sectional shape of each CoPt nanowire perpendicular to the direction of extension was configured as illustrated in FIG. 2A. Specifically, each CoPt nanowire had a layered structure of $\{Co (1.8 nm)/Pt (2.4 nm)\}_6$ that was formed by alternating a 1.8 nm thick Co layer and a 2.4 nm thick Pt layer 6 times to a thickness of 25.2 nm. The atomic composition ratio of each CoPt nanowire was Co:Pt = 1:1. The cross-sectional shape of each CoPt nanowire was rectangular, the width was 20 nm, and the aspect ratio was 1.3. The length of one CoPt nanowire was 75 $\mu$m, and 46,000 of them were formed in parallel and equally spaced. The distance between adjacent CoPt nanowires was about 130 nm.

Then, heat treatment was carried out in an RTA apparatus (MILA-5000UHV available from Advance Science and Engineering Corporation) in an atmosphere containing 3 vol% hydrogen with the balance being argon gas, at the heat treatment temperature of 650 °C for four different heat treatment times of 120 mins, 180 mins, 300 mins, and 360 mins.

<Characteristic Evaluation>

(1) SEM Observation

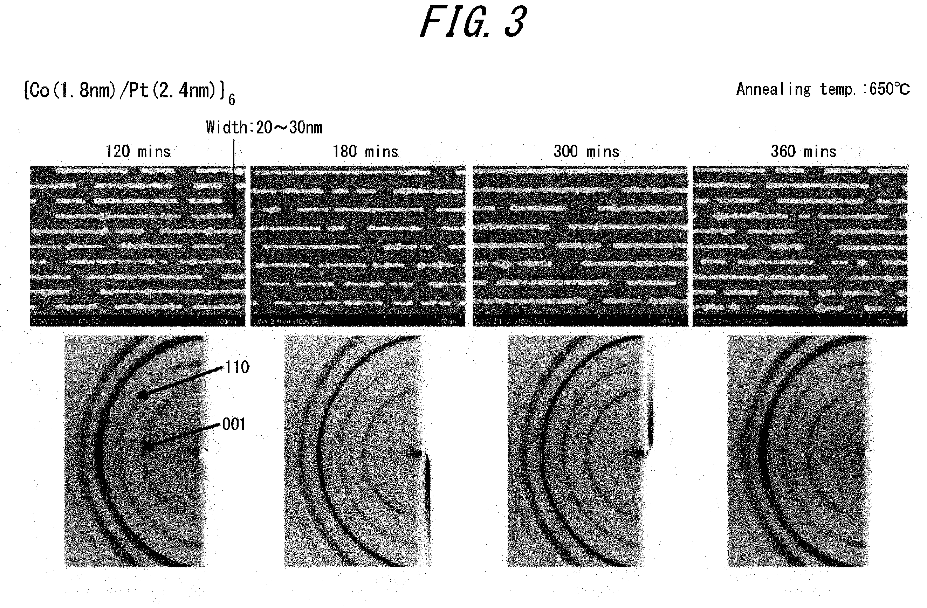

The surface of each sample was observed by SEM. The results are illustrated in FIG. 3.

(2) GI-XRD Measurement

For each sample, the crystal structure of CoPt nanowires after the heat treatment was evaluated by grazing incidence X-ray diffraction (GI-XRD). X-ray synchrotron radiation with an energy of 11.7 keV was incident horizontally on each sample while the sample was oscillated 0° to 2°. Diffraction images were taken with a curved imaging plate to obtain a two-dimensional diffraction pattern. For each sample, the obtained GI-XRD pattern is illustrated in FIG. 3.

(3) VSM Measurement (Magnetization Properties)

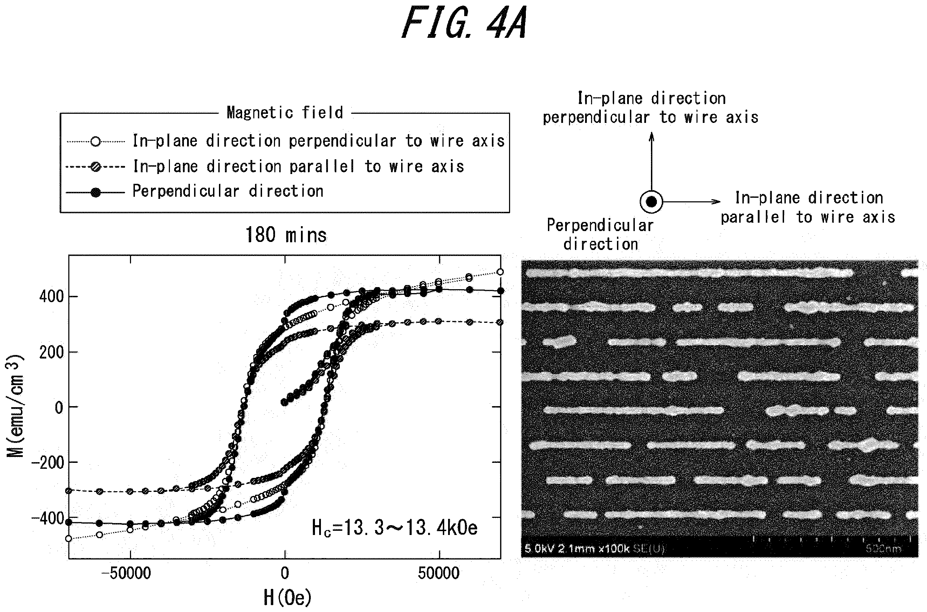

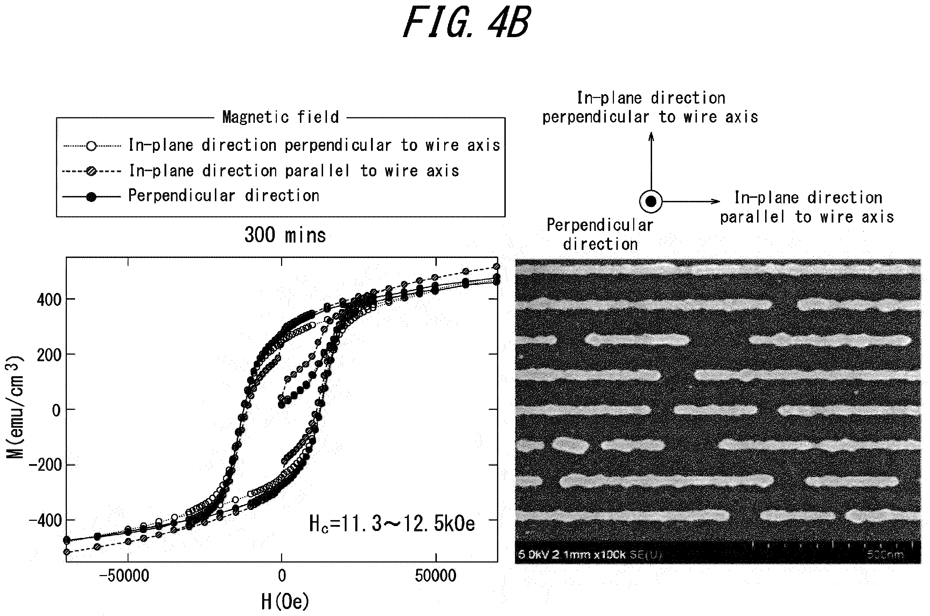

The magnetic properties of each sample were measured using a vibrating sample magnetometer (VSM) on a magnetic properties measurement system (MPMS3 available from Quantum Design Japan) by sweeping external magnetic fields, maximum of 70 kOe under vacuum at room temperature (27 °C), in (i) in-plane direction perpendicular to the wire axis, (ii) in-plane direction parallel to the wire axis, and (iii) perpendicular direction. The coercive force Hc was defined as the absolute value of the magnetic field required to reduce the magnetization M to zero. The saturation magnetization Ms was defined as the value of magnetization at an applied magnetic field of +70 kOe. As representatives of the samples, the magnetic hysteresis loops (M-H curves) for the instances with the heat treatment times of 180 mins and 300 mins are illustrated in FIGS. 4A and 4B.

<Consideration>

Referring to the GI-XRD pattern in FIG. 3 (lower side), superlattice reflections due to $L1_0$-ordered CoPt 001,110 were observed at all heat treatment times of 120 mins, 180 mins, 300 mins, and 360 mins. This demonstrates that in all samples, CoPt was $L1_0$-ordered, and $L1_0$-ordered CoPt ferromagnetic nanowires were obtained.

It can be seen from FIGS. 4A and 4B that when the heat treatment time was 180 mins, the coercive force Hc was 13.3 kOe to 13.4 kOe, and when the heat treatment time was 300 mins, the coercive force Hc was 11.3 kOe to 12.5 kOe. In both cases, high coercive force was obtained. Although not illustrated in the figures, when the heat treatment time was 120 mins, the coercive force Hc was 11.1 kOe to 12.3 kOe, and when the heat treatment time was 360 mins, the coercive force Hc was 8.8 kOe to 10.1 kOe. Since the coercive force Hc was equal in the in-plane direction perpendicular to the wire axis, the in-plane direction parallel to the wire axis, and the perpendicular direction, an $L1_0$ ferromagnetic material was isotropically generated. The saturation magnetization Ms was 400 emu/cm$^3$ to 480 emu/cm$^3$ for the heat treatment time of 120 mins, 410 emu/cm$^3$ to 480 emu/cm$^3$ for the heat treatment time of 180 mins, 390 emu/cm$^3$ to 450 emu/cm$^3$ for the heat treatment time of 300 mins, and 380 emu/cm$^3$ to 450 emu/cm$^3$ for the heat treatment time of 360 mins.

Referring to the SEM image in FIG. 3 (upper side), the obtained $L1_0$-ordered CoPt ferromagnetic nanowires had a width of 20 nm to 30 nm and a length of at least twice the width, although the CoPt nanowires were interrupted for all heat treatment times of 120 mins, 180 mins, 300 mins, and 360 mins.

[Experimental Example 2]

<Sample Preparation>

CoPt nanowires were formed on a SiO$_2$/Si substrate under the same conditions as in Experimental Example 1, except that the cross-sectional shape perpendicular to the direction in which the CoPt nanowires extended was configured as illustrated in FIG. 2B. Specifically, each CoPt nanowire had a layered structure of {Co (1.8 nm)/Pt (2.4 nm)}$_{12}$ that was formed by alternating a 1.8 nm thick Co layer and a 2.4 nm thick Pt layer 12 times to a thickness of 50.4 nm. The atomic composition ratio of each CoPt nanowire was Co:Pt = 1:1. The cross-sectional shape of each CoPt nanowire was rectangular, the width was 18 nm, and the aspect ratio was 2.8. The length of one CoPt nanowire was 75 $\mu$m, and 46,000 of them were formed in parallel and equally spaced. The distance between adjacent CoPt nanowires was about 130 nm.

Then, heat treatment was carried out in an RTA apparatus (MILA-5000UHV available from Advance Science and Engineering Corporation) in an atmosphere containing 3 vol% hydrogen with the balance being argon gas, at the heat treatment temperature of 650 °C for three different heat treatment times of 30 mins, 60 mins, and 90 mins.

<Characteristic Evaluation>

(1) SEM Observation

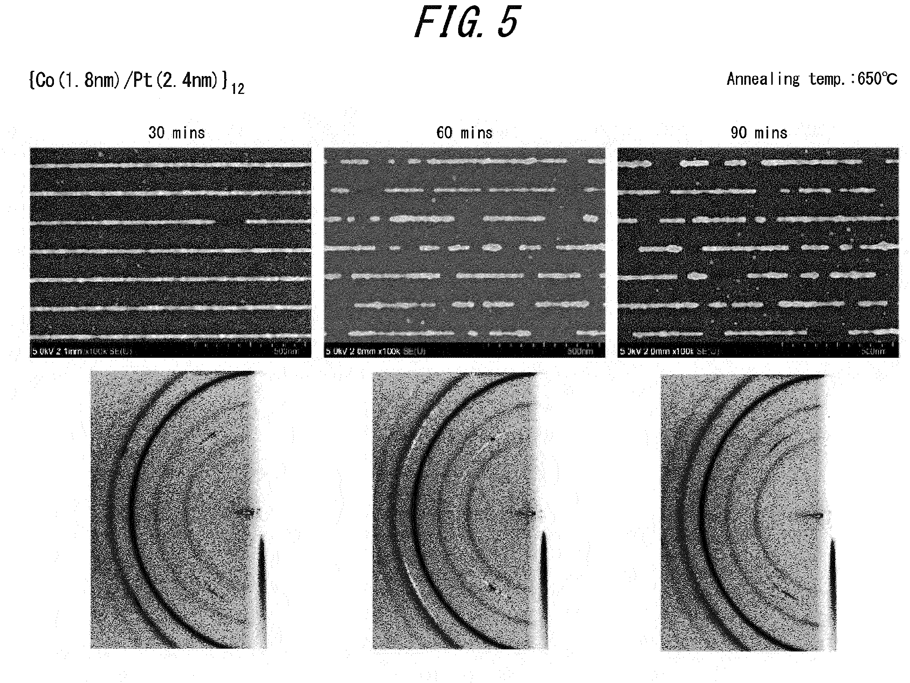

The surface of each sample was observed by SEM. The results are illustrated in FIG. 5.

(2) GI-XRD Measurement

For each sample, the crystal structure of CoPt nanowires after heat treatment was evaluated by GI-XRD. The specific measurement method was the same as in Experimental Example 1. For each sample, the obtained GI-XRD pattern is illustrated in FIG. 5.

<Consideration>

Referring to the GI-XRD pattern in FIG. 5 (lower side), superlattice reflections due to $L1_0$-ordered CoPt 001,110 were observed at all heat treatment times of 30 mins, 60 mins, and 90 mins. This demonstrates that in all samples, CoPt was $L1_0$-ordered, and $L1_0$-ordered CoPt ferromagnetic nanowires were obtained.

As illustrated in FIG. 5 (upper side), CoPt nanowires were interrupted when the heat treatment time was 60 mins and 90 mins, whereas ordered CoPt ferromagnetic nanowires with sufficient length were obtained when the heat treatment time was 30 mins, with almost no interruption of CoPt nanowires. In any of these samples, the resulting $L1_0$-ordered CoPt ferromagnetic nanowires had a width of 20 nm to 30 nm and a length of at least twice the width.

[Experimental Example 3]

<Sample Preparation>

CoPt nanowires were formed on a SiO$_2$/Si substrate under the same conditions as in Experimental Example 1, except that the cross-sectional shape perpendicular to the direction in which the CoPt nanowires extended was configured as illustrated in FIG. 2C. In other words, each CoPt nanowire had a layered structure of $\{Co\ (3.6\ nm)/Pt\ (4.8\ nm)\}_6$ that was formed by alternating a 3.6 nm thick Co layer and a 4.8 nm thick Pt layer 6 times to a thickness of 50.4 nm. The atomic composition ratio of each CoPt nanowire was Co:Pt = 1:1. The cross-sectional shape of each CoPt nanowire was rectangular, the width was 20 nm, and the aspect ratio was 2.5. The length of one CoPt nanowire was 75 $\mu$m, and 46,000 of them were formed in parallel and equally spaced. The distance between adjacent CoPt nanowires was about 130 nm.

Then, heat treatment was carried out in an RTA apparatus (MILA-5000UHV available from Advance Science and Engineering Corporation) in an atmosphere containing 3 vol% hydrogen with the balance being argon gas, at the heat treatment temperature of 650 °C for three different heat treatment times of 30 mins, 60 mins, and 90 mins.

<Characteristic Evaluation>

(1) SEM Observation

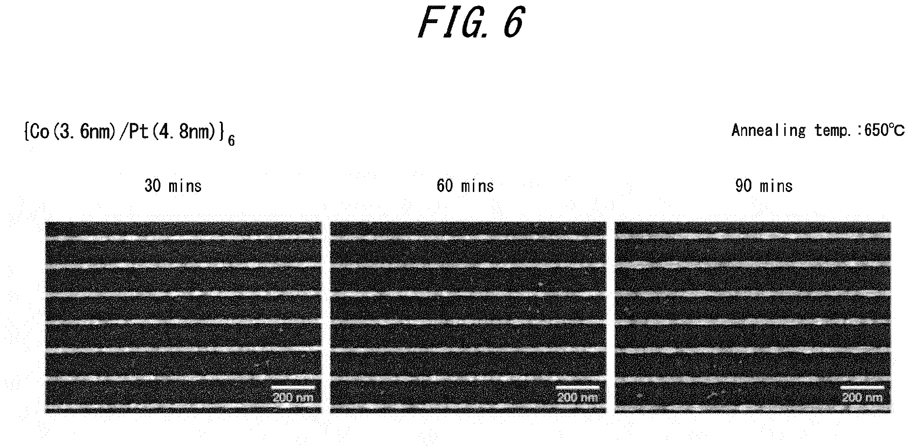

The surface of each sample was observed by SEM. The results are illustrated in FIG. 6.

(2) GI-XRD Measurement

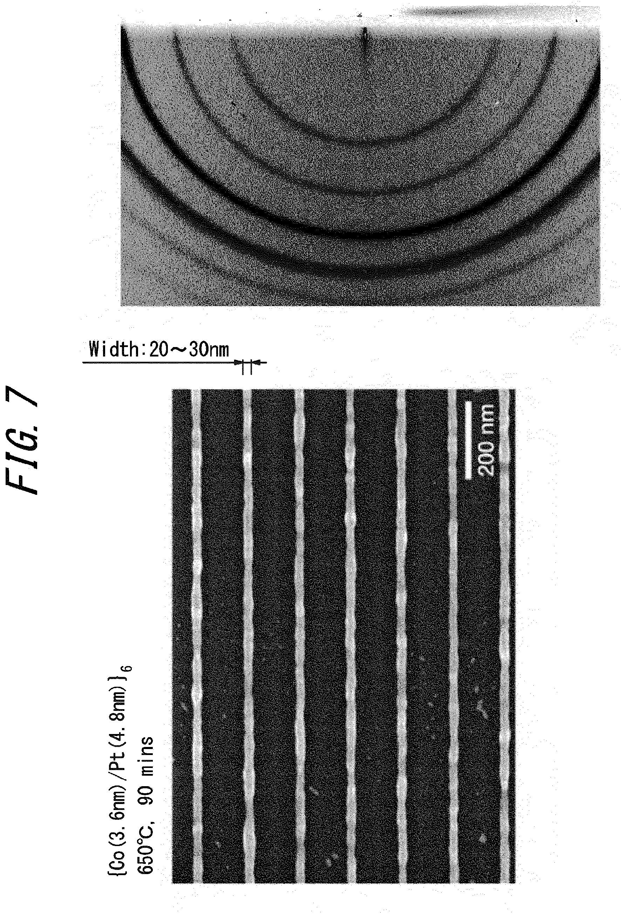

For each sample, the crystal structure of CoPt nanowires after heat treatment was evaluated by GI-XRD. The specific measurement method was the same as in Experimental Example 1. As a representative of the samples, the GI-XRD pattern obtained for the sample with the heat treatment time of 90 mins is illustrated in FIG. 7.

(3) VSM Measurement (Magnetization Properties)

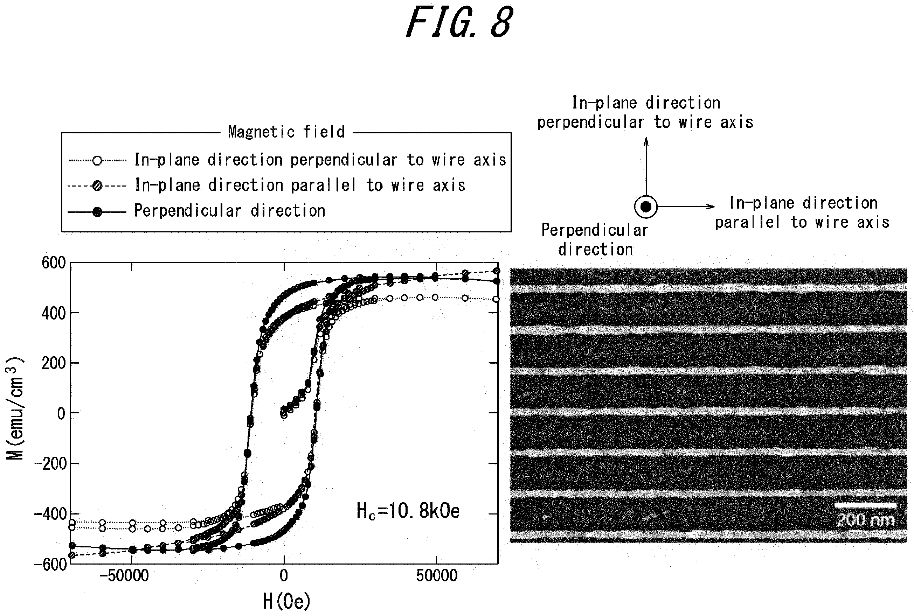

The magnetic properties of each sample were measured using a vibrating sample magnetometer (VSM) on a magnetic properties measurement system (MPMS3 available from Quantum Design Japan) by sweeping external magnetic fields, maximum of 70 kOe under vacuum at room temperature (27 °C), in (i) in-plane direction perpendicular to the wire axis, (ii) in-plane direction parallel to the wire axis, and (iii) perpendicular direction. The definitions of coercive force Hc and saturation magnetization Ms are as described in Experimental Example 1. As a representative of the samples, the magnetic hysteresis loops (M-H curves) are illustrated in FIG. 8 for the instance with the heat treatment time of 90 mins.

(4) TEM and STEM Observation

Each sample was subjected to TEM and STEM observation. As a representative of the samples, the cross-sectional TEM image perpendicular to the direction in which the ordered CoPt ferromagnetic nanowires extended is illustrated in FIG. 9 for the sample with the heat treatment time of 90 mins. FIG. 10 illustrates a cross-sectional TEM image perpendicular to the width direction along the direction in which the ordered CoPt ferromagnetic nanowires extended obtained for the sample with the heat treatment time of 90 mins. FIGS. 11A, 11B, 11C, and 11D illustrate STEM images of an ordered CoPt ferromagnetic nanowire obtained for the sample with the heat treatment time of 90 mins. FIGS. 11B and 11C are magnified STEM images of the top (yellow line) and bottom (blue line) of the nanowire in FIG. 11A, respectively, and FIG. 11D is a magnified STEM image of the side of the ordered CoPt ferromagnetic nanowire.

<Consideration>

Referring to the GI-XRD pattern in FIG. 7, superlattice reflections due to $L1_0$-ordered CoPt 001,110 were observed for the instance with the heat treatment time of 90 mins. This demonstrates that CoPt was $L1_0$-ordered, and $L1_0$-ordered CoPt ferromagnetic nanowires were obtained. The same was true for the samples with the heat treatment times of 30 mins and 60 mins.

It can be seen from FIG. 8 that when the heat treatment temperature was 90 mins, the coercive force Hc was as high as 10.8 kOe and the saturation magnetization Ms was 440 $emu/cm^3$ to 560 $emu/cm^3$. Although not illustrated in the figure, when the heat treatment temperature was 30 mins, the coercive force Hc was 8.3 kOe and the saturation magnetization Ms was 400 $emu/cm^3$ to 500 $emu/cm^3$. When the heat treatment temperature was 60 mins, the coercive force Hc was 9.5 kOe and the saturation magnetization Ms was 410 $emu/cm^3$ to 550 $emu/cm^3$.

Referring to the SEM image in FIG. 6, ordered CoPt ferromagnetic nanowires with sufficient length could be obtained with almost no interruption of CoPt nanowires for all heat treatment times of 30 mins, 60 mins, and 90 mins. The widths ranged from 20 nm to 30 nm.

As illustrated in FIGS. 9 and 11A, the cross-sectional shape perpendicular to the direction in which the resulting ordered CoPt ferromagnetic nanowires extended was generally rounded, except for the portions of contact with the substrate. As illustrated in FIG. 10, the ordered CoPt ferromagnetic nanowires contained a plurality of grains connected together. As illustrated in FIGS. 11A, 11B, 11C, and 11D, scattering of [001] and [110] appeared even though electron beam scattering occurred in the central part, indicating that the entire area including the central part was $L1_0$-ordered. Twinned crystals were also observed as illustrated in FIGS. 11B, 11C, and 11D. That is, two c-axes (indicated by white and green arrows) originating from the twinned crystals appeared at the top (FIG. 11B) and bottom (FIG. 11C) of the same grain. Comparing the white and green arrows at the top with those at the bottom, each is in exactly the same direction. This indicates that the inside of the grain was a single crystal including twinned crystals. In FIGS. 11C and 11D, the boundaries of the twinned crystals are indicated by red lines. A grain boundary was also observed as illustrated in FIG. 11D. In the righthand grain, no clear lattice fringes are visible, indicating that the c-axis of a single crystal is oriented in a different direction.

The thickness of each of the Co and Pt layers is twice as thick as in Experimental Example 2, while the thickness of the CoPt nanowires is the same. In the case of each layer being thick, interlayer interdiffusion is more difficult to occur than in the thin case, and it takes a longer time for the interlayer interdiffusion to be completed.

CoPt is $L1_0$-ordered under conditions of stress at elevated temperatures. The nanowire structure in this experimental example has an extremely small curvature radius of 15 nm or less, and $L1_0$ ordering proceeds as described in paragraph 0066.

Co and Pt atoms diffuse across the nanowire surface as the nanowire structure with a rectangular cross-sectional shape is transformed into a rounded cross-sectional shape. This extremely high tensile stress situation will promote $L1_0$ ordering during surface diffusion. If the thickness of Co and Pt is thin, interlayer interdiffusion occurs in a short time and A1-disordered phases are formed and mixed. As the thickness of each layer increases, since Pt is harder than Co and has a lower surface self-diffusion coefficient than that of Co, the presence of Pt layers makes it difficult to enter the interruption mode due to Rayleigh instability when the interlayer interdiffusion has not finished. Furthermore, in this state, Co and Pt atoms are easily $L1_0$-ordered through surface self-diffusion. This is the nanostructure-induced $L1_0$ ordering process. Therefore, in order to promote $L1_0$ ordering, thicker Co and Pt layers as in this experimental example are more preferable than in the thinner case of Experimental Example 2.

INDUSTRIAL APPLICABILITY

The ordered-alloy ferromagnetic nanowire structure according to the present disclosure has high industrial applicability with potential applications in spintronics devices (magnetic devices) such as MRAMs, TMR heads in HHDs, and FM-SETs.

REFERENCE SIGNS LIST

100    Ordered CoPt ferromagnetic nanowire structure
10     Substrate
10A    Exposed portion of substrate
12     Electron beam resist film
14     Mask pattern
16     CoPt nanowire (Co/Pt alternate layered structure)
16A    Co layer (first layer)
16B    Pt layer (second layer)
18     Ordered CoPt ferromagnetic nanowire

**Claims**

1. A method of producing an ordered-alloy ferromagnetic nanowire structure, the method comprising:

   forming a nanowire on or above a substrate, the nanowire having a width of 100 nm or less and a length of at least twice the width, and made of an iron group element and a platinum group element; and
   subjecting the nanowire to heat treatment to obtain an ordered-alloy ferromagnetic nanowire structure in which an ordered-alloy ferromagnetic nanowire made of an ordered alloy of the iron group element and the platinum group element is formed on or above the substrate.

2. The method of producing an ordered-alloy ferromagnetic nanowire structure according to claim 1, wherein a ratio of thickness to width is 0.7 or more and 3.0 or less in a cross-section perpendicular to a direction in which the nanowire extends.

3. The method of producing an ordered-alloy ferromagnetic nanowire structure according to claim 1 or 2, wherein the length of the nanowire is 800 nm or more.

4. The method of producing an ordered-alloy ferromagnetic nanowire structure according to any one of claims 1 to 3, wherein the nanowire is formed on the substrate.

5. The method of producing an ordered-alloy ferromagnetic nanowire structure according to any one of claims 1 to 4, wherein the substrate is a magnesium oxide substrate, an alumina substrate, a strontium titanate substrate, or a silicon substrate with a silicon oxide film formed on a surface thereof.

6. The method of producing an ordered-alloy ferromagnetic nanowire structure according to any one of claims 1 to 5, wherein the nanowire is fabricated by alternately depositing the iron group element and the platinum group element by electron-beam evaporation such that the nanowire is formed from an alternate layered structure of a first layer and a second layer, the first layer made of the iron group element and the second layer made of the platinum group element.

7. The method of producing an ordered-alloy ferromagnetic nanowire structure according to claim 6, wherein the first layer has a thickness of 2.0 nm or more and 15 nm or less, the second layer has a thickness of 3.0 nm or more and 15 nm or less, and a total number of layers of the first layer and the second layer is 2 or more and 24 or less.

8. The method of producing an ordered-alloy ferromagnetic nanowire structure according to any one of claims 1 to 5, wherein the nanowire is fabricated by depositing the iron group element and the platinum group element simultaneously by electron-beam evaporation or sputtering such that the nanowire is formed from a composite of the iron group element and the platinum group element.

9. The method of producing an ordered-alloy ferromagnetic nanowire structure according to any one of claims 1 to 8, wherein the heat treatment is performed in an atmosphere containing hydrogen and inert gas.

10. The method of producing an ordered-alloy ferromagnetic nanowire structure according to any one of claims 1 to 9, wherein the heat treatment is performed at a heat treatment temperature of 500 °C or higher and 900 °C or lower for a heat treatment time of 30 minutes or more and 360 minutes or less.

11. The method of producing an ordered-alloy ferromagnetic nanowire structure according to any one of claims 1 to 10, wherein the nanowire has an atomic composition ratio of the iron group element to the platinum group element of 1:1 such that the ordered-alloy ferromagnetic nanowire made of an $L1_0$-ordered alloy is obtained.

12. The method of producing an ordered-alloy ferromagnetic nanowire structure according to any one of claims 1 to 10, wherein the nanowire has an atomic composition ratio of the iron group element to the platinum group element of 1:3 or 3:1 such that the ordered-alloy ferromagnetic nanowire made of an $L1_2$-ordered alloy is obtained.

13. The method of producing an ordered-alloy ferromagnetic nanowire structure according to any one of claims 1 to 12, wherein the iron group element is Co, Fe, or Ni and the platinum group element is Pt or Pd.

14. An ordered-alloy ferromagnetic nanowire structure comprising:

   a substrate; and
   an ordered-alloy ferromagnetic nanowire formed on or above the substrate, having a width of 100 nm or less and a length of at least twice the width, and made of an ordered alloy of an iron group element and a platinum group element.

15. The ordered-alloy ferromagnetic nanowire structure according to claim 14, wherein the ordered-alloy ferromagnetic nanowire has a length of 800 nm or more.

16. The ordered-alloy ferromagnetic nanowire structure according to claim 14 or 15, wherein the ordered-alloy ferromagnetic nanowire is formed on the substrate.

17. The ordered-alloy ferromagnetic nanowire structure according to any one of claims 14 to 16, wherein the substrate is a magnesium oxide substrate, an alumina substrate, a strontium titanate substrate, or a silicon substrate with a silicon oxide film formed on a surface thereof.

18. The ordered-alloy ferromagnetic nanowire structure according to any one of claims 14 to 17, wherein the ordered-alloy ferromagnetic nanowire is an $L1_0$-ordered alloy.

19. The ordered-alloy ferromagnetic nanowire structure according to any one of claims 14 to 17, wherein the ordered-alloy ferromagnetic nanowire is an $L1_2$-ordered alloy.

20. The ordered-alloy ferromagnetic nanowire structure according to any one of claims 14 to 19, wherein a contact width of the ordered-alloy ferromagnetic nanowire with the substrate is smaller than a maximum width of the ordered-alloy ferromagnetic nanowire in a cross-section perpendicular to a direction in which the ordered-alloy ferromagnetic nanowire extends.

21. The ordered-alloy ferromagnetic nanowire structure according to any one of claims 14 to 20, wherein the ordered-alloy ferromagnetic nanowire contains a plurality of grains connected together, each of the plurality of grains made of a single crystal including twinned crystals.

22. The ordered-alloy ferromagnetic nanowire structure according to any one of claims 14 to 21, wherein the iron group element is Co, Fe, or Ni and the platinum group element is Pt or Pd.

FIG. 1A

FIG. 1B

10A

FIG. 1C

FIG. 1D

16
16B
16A

FIG. 1E

100

18

**FIG. 2A**

{Co(1.8nm)/Pt(2.4nm)}$_6$

**FIG. 2B**

{Co(1.8nm)/Pt(2.4nm)}$_{12}$

**FIG. 2C**

{Co(3.6nm)/Pt(4.8nm)}$_6$

16

50.4nm

16B

16A

10

16

50.4nm

16B

16A

10

16

25.2nm

~20nm

16B

16A

10

## FIG. 3

{Co(1.8nm)/Pt(2.4nm)}$_6$

Annealing temp.:650℃

Width:20~30nm

120 mins　　　180 mins　　　300 mins　　　360 mins

110

001

# FIG. 4A

Magnetic field

····o···· In-plane direction perpendicular to wire axis

····⊘···· In-plane direction parallel to wire axis

—●— Perpendicular direction

180 mins

$H_c$=13. 3～13. 4kOe

In-plane direction perpendicular to wire axis

In-plane direction parallel to wire axis

Perpendicular direction

# FIG. 4B

**— Magnetic field —**
- ·······○······· In-plane direction perpendicular to wire axis
- ----◐---- In-plane direction parallel to wire axis
- ——●—— Perpendicular direction

300 mins

In-plane direction perpendicular to wire axis

Perpendicular direction

In-plane direction parallel to wire axis

$H_c=11.3\sim12.5kOe$

5.0kV 2.1mm x100k SE(U)    500nm

## FIG. 5

{Co(1.8nm)/Pt(2.4nm)}$_{12}$

Annealing temp.:650°C

| 30 mins | 60 mins | 90 mins |

EP 4 403 514 A1

FIG. 6

## FIG. 7

{Co(3.6nm)/Pt(4.8nm)}₆
650°C, 90 mins

Width:20～30nm

200 nm

EP 4 403 514 A1

FIG. 8

FIG. 9

Observed in in-plane direction parallel to wire axis

200 nm

In-plane direction perpendicular to wire axis

In-plane direction parallel to wire axis

Perpendicular direction

50nm

50nm

# FIG. 10

Observed in in-plane direction perpendicular to wire axis

In-plane direction perpendicular to wire axis

In-plane direction parallel to wire axis

Perpendicular direction

50nm

50nm

200 nm

# FIG. 11A

# FIG. 11B

## FIG. 11C

5 nm

FIG. 11D

## INTERNATIONAL SEARCH REPORT

| International application No. |
|---|
| **PCT/JP2022/034863** |

**A. CLASSIFICATION OF SUBJECT MATTER**

*B82B 1/00*(2006.01)i
FI: B82B1/00

According to International Patent Classification (IPC) or to both national classification and IPC

**B. FIELDS SEARCHED**

Minimum documentation searched (classification system followed by classification symbols)

B82B1/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2016-42399 A (WASEDA UNIVERSITY) 31 March 2016 (2016-03-31) paragraphs [0013]-[0061], fig. 1-8 | 1-22 |
| A | JP 2009-301699 A (SAMSUNG ELECTRONICS CO., LTD.) 24 December 2009 (2009-12-24) paragraphs [0017]-[0040], fig. 1-3 | 1-22 |
| A | JP 2008-115469 A (KOREA UNIVERSITY, INDUSTRY & ACADEMY COLLABORATION FOUNDATION) 22 May 2008 (2008-05-22) paragraphs [0017]-[0041], fig. 1-9 | 1-22 |
| A | WO 2007/081381 A2 (THE REGENTS OF THE UNIVERSITY OF CALIFORNIA) 19 July 2007 (2007-07-19) paragraphs [0059]-[0089], fig. 3-17 | 1-22 |
| A | JP 2005-52956 A (CANON INC.) 03 March 2005 (2005-03-03) paragraphs [0016]-[0061], fig. 1-8 | 1-22 |

☐ Further documents are listed in the continuation of Box C. ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **25 November 2022** | **06 December 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/034863**

| Patent document cited in search report | | | Publication date (day/month/year) | Patent family member(s) | Publication date (day/month/year) |
|---|---|---|---|---|---|
| JP | 2016-42399 | A | 31 March 2016 | (Family: none) | |
| JP | 2009-301699 | A | 24 December 2009 | US 2009/0310241 A1 paragraphs [0026]-[0049], fig. 1-3 KR 10-2009-0130757 A CN 101609716 A | |
| JP | 2008-115469 | A | 22 May 2008 | US 2009/0155617 A1 paragraphs [0024]-[0047], fig. 1-9 EP 1925696 A2 KR 10-2008-0039724 A | |
| WO | 2007/081381 | A2 | 19 July 2007 | US 2008/0268288 A1 paragraphs [0058]-[0087], fig. 3-17 | |
| JP | 2005-52956 | A | 03 March 2005 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

•   JP 2016042399 A

**Non-patent literature cited in the description**

•   **R. TOYAMA et al.** Ti underlayer effect on the ordering of CoPt in (Cp/Pt)4 multilayer thin films on Si/SiO2 substrates. *Jpn. J. Appl. Phys.,* 2020, vol. 59, 075504
•   **YOSHIHARU HOTTA et al.** Phase Transformation and Photoemission Electron Microscopy of Fe50Pd50-xNix Processed by Severe Plastic Deformation. *SPring-8/SACLA Research Report,* 2021, vol. 8 (3), 493-496

•   **R. TOYAMA et al.** Formation of L10-ordered CoPt during interdiffusion of electron-beam-deposited Pt/Co bilayer thin films on Si/SiO2 substrates by rapid thermal annealing. *Mater. Res. Express,* 2020, vol. 7, 066101